(19) Europäisches Patentamt

European Patent Office

Office européen des brevets

(11) **EP 1 035 711 B1**

(12) **FASCICULE DE BREVET EUROPEEN**

(45) Date de publication et mention
de la délivrance du brevet:
**19.04.2006 Bulletin 2006/16**

(51) Int Cl.:
*H03M 1/18* *(2006.01)*   *H04M 1/60* *(2006.01)*

(21) Numéro de dépôt: **00400657.3**

(22) Date de dépôt: **09.03.2000**

(54) **Téléphone mobile et procédé de numérisation**

Mobilfon und Digitalisierungsverfahren

Mobile phone and digitalisation method

(84) Etats contractants désignés:
**DE FR GB**

(30) Priorité: **11.03.1999 FR 9903022**

(43) Date de publication de la demande:
**13.09.2000 Bulletin 2000/37**

(73) Titulaire: **SAGEM Communication**
**75015 Paris (FR)**

(72) Inventeur: **Romao, Fernando**
**78360 Montesson (FR)**

(74) Mandataire: **Schmit, Christian Norbert Marie**
**SCHMIT-CHRETIEN-SCHIHIN**
**8, place du Ponceau**
**95000 Cergy (FR)**

(56) Documents cités:
**EP-A- 0 856 947**      **US-A- 5 111 202**

• **"FLOATING-POINT APPROACH TO A/D CONVERSION" IBM TECHNICAL DISCLOSURE BULLETIN, US, IBM CORP. NEW YORK, vol. 34, no. 4B, page 120-123 XP000189528 ISSN: 0018-8689**

**Description**

La présente invention a pour objet un téléphone mobile et un procédé de numérisation. Son domaine d'application est celui de la téléphonie mobile. Le but de l'invention est d'augmenter la précision de numérisation des signaux reçus dans des téléphones mobiles, et la capacité de réaction des téléphones mobiles face à des variations rapides de la puissance du signal reçu.

Un téléphone mobile écoute son environnement radioélectrique grâce à une antenne. L'antenne est connectée à un dispositif de démodulation. Le dispositif de démodulation fournit des signaux démodulés qui sont soumis au dispositif de numérisation. Celui-ci est usuellement constitué d'un amplificateur analogique à gain variable commandé par un microprocesseur, et d'un convertisseur analogique numérique, en général à 10 bits. La mise en oeuvre d'un tel dispositif de numérisation pose deux problèmes.

Un premier problème est un problème de précision. En effet avec un convertisseur 10 bits on obtient 1024 ($2^{10}$) niveaux possibles, soit une dynamique de 60 dB. Or la dynamique usuelle des signaux reçus en téléphonie mobile est de l'ordre de 100 dB. Pour résoudre ce problème on prévoit un amplificateur à gain variable en entrée du convertisseur. L'amplificateur à gain variable permet de combler la différence de 40 dB, entre les niveaux des signaux reçus par le téléphone mobile et les capacités de numérisation du convertisseur.

Un deuxième problème est lié à l'amplificateur à gain variable. Le deuxième problème apparaît lorsque les variations de puissance du signal radioélectrique capté par l'antenne sont très rapides, par exemple, un évanouissement ou un pic de signal. De tels phénomènes se produisent, entre autre, lors d'un passage sous un pont ou dans un tunnel. Ils peuvent même être très rapide si le téléphone mobile se trouve dans un train à grande vitesse ou un avion par exemple.

Normalement des signaux de signalisations renseignent le téléphone mobile, par anticipation sur le niveau d'amplification auquel il doit se caler. Cependant dans le cadre des prochaines normes ces signaux de signalisation tendent à se raréfier.

Le problème des amplificateurs à gain variable est celui de la lenteur de leur ajustement. Cette lenteur résulte de la présence de filtres passe bas mis en place dans les boucles d'asservissements des commandes automatique de gain des amplificateurs à gain variable. Le problème de ces amplificateurs à gain variables est aussi lié au caractère analogique de leur structure, qui se prête mal à une intégration des ces amplificateurs à gain variable dans des circuits intégrés numériques.

Une solution simple pour résoudre ces problèmes consiste à se débarrasser des amplificateurs à gain variable. Il suffirait d'utiliser un convertisseur analogique numérique ayant une dynamique de 100 dB. Les convertisseurs ayant une dynamique de 6 dB par bit, un rapide calcul montre qu'il faudrait un convertisseur de 16 ou 17 bits. L'emploi d'un tel convertisseur soulève, dans un premier temps, des problèmes d'intégration. En effet un convertisseur 16 bits est beaucoup plus gros qu'un convertisseur 10 bits. Cela revient à dire qu'il faudrait plus de surface de silicium pour l'intégrer, donc son prix de revient serait plus élevé. Cela signifie aussi qu'il consommerait plus, donc son utilisation réduirait l'autonomie du téléphone mobile. De plus le signal à échantillonner ayant une fréquence qui tend à augmenter, l'utilisation d'un convertisseur 16 bits entraînerait des fréquences de conversion interne très élevées de l'ordre de plusieurs dizaines de GHz et une complexité largement accrue. Ce qui est prohibitif en termes de coûts de mise en oeuvre et de sensibilité aux divers bruits des circuits intégrés.

Le document US 5 111 202 décrit un dispositif de numérisation comportant deux chaînes de numérisation, l'une d'elles comportant un limiteur, ce qui entraîne une distorsion du signal et une perte énergétique

Dans l'invention on remédie à ces problèmes en remplaçant la chaîne de numérisation unique par deux chaînes de numérisation. Chacune de ces deux chaînes est caractérisée par un gain différent et comporte, dans un exemple, un convertisseur analogique numérique 12 bits. Les gains sont fixes, ce qui supprime l'asservissement par le microprocesseur et les traitements attenants. Le temps ainsi libéré permet au microprocesseur de se livrer à d'autres opérations. Les deux chaînes traitent simultanément les signaux démodulés reçus. L'utilisation de convertisseurs 12 bits permet un gain de précision par rapport aux solutions existantes à 10 bits. Un convertisseur 12 bits n'est guère plus complexe qu'un convertisseur 10 bits, et l'intégration de deux convertisseurs induit une occupation bien plus faible que celle d'un seul convertisseur 16 bits. Le microprocesseur, aidé éventuellement d'un processeur de traitement du signal, n'a alors plus qu'à choisir lequel des deux convertisseurs lui fournit le résultat le plus exploitable. Il n'y a jamais de perte de temps due à l'ajustement.

L'invention a donc pour objet un téléphone mobile comportant :

- un dispositif de démodulation de signaux radioélectriques reçus par le téléphone mobile, et produisant des signaux démodulés, et

- un dispositif de numérisation des signaux démodulés,

caractérisé en ce qu'il comporte deux chaînes de numérisation en parallèle, et ayant chacune un gain distinct.

L'invention a aussi pour objet un procédé de numérisation de signaux radioélectriques par un téléphone mobile caractérisé en ce que :

- on reçoit un signal radioélectrique et on produit deux signaux démodulés,
- on amplifie les signaux démodulé avec deux gains différents, afin d'obtenir deux signaux amplifiés d'amplitudes distinctes,

- on numérise les deux signaux amplifiés afin d'obtenir des signaux numérisés, et
- on choisit un des deux signaux numérisés.

L'invention sera mieux comprise la lecture de la description qui suit et à l'examen des figures qui l'accompagnent. Celles-ci ne sont présentées qu'à titre indicatif et nullement limitatif de l'invention. Les figures montrent :

- Figure 1 : un téléphone mobile muni des différents moyens nécessaires à la réalisation de l'invention ;
- Figure 2 : une variante préférée de réalisation des chaînes de numérisation ;
- Figure 3 : une illustration des étapes du procédé selon l'invention ;
- Figure 4: une illustration du traitement par l'invention de trois signaux S1, S2 et S3.

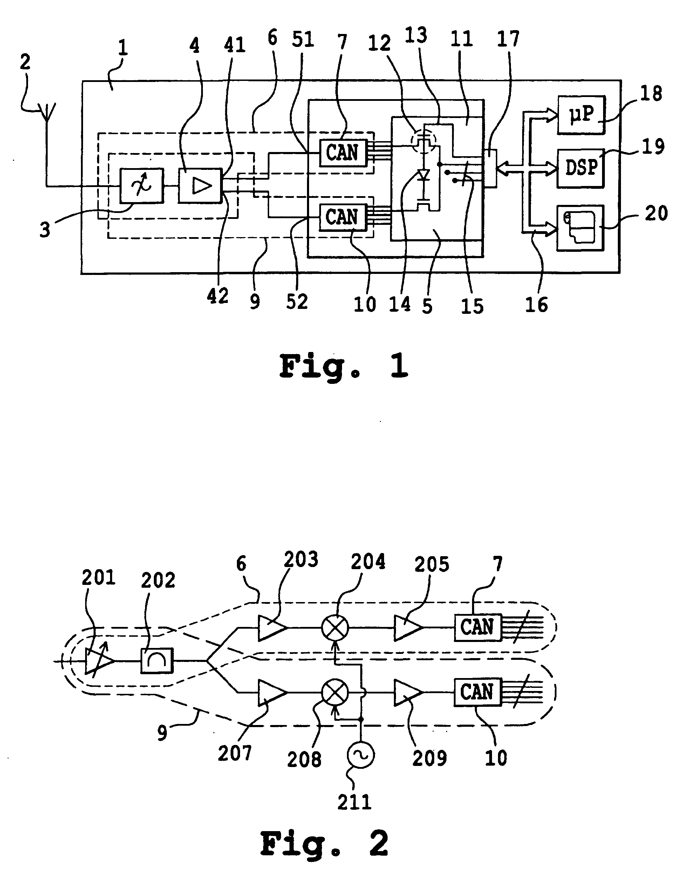

La figure 1 montre un téléphone 1 mobile. Sa représentation est purement formelle. Le téléphone 1 comporte une antenne 2, connectée à un dispositif 3 de démodulation. Un premier dispositif de préamplification dans le démodulateur 3 est à gain variable. Généralement deux valeurs sont données à son gain. Ceci permet d'éviter la saturation des premiers étages de réception quand le signal d'entrée est très important. Le dispositif 3 est connecté à un dispositif 4 d'amplification. Deux sorties 41 et 42 du dispositif 4 sont respectivement connecté à un dispositif 5 de numérisation par deux entrées 51 et 52. Le téléphone 1 reçoit par l'antenne 2 des signaux radioélectriques. L'antenne 2 transmet ces signaux radioélectriques aux dispositifs 3 puis 4 qui les transforment jusqu'à obtenir des signaux démodulés et amplifiés. Le dispositif 5 traite ces signaux démodulés pour les numériser.

Le dispositif 5 selon l'invention contient deux convertisseurs analogiques numériques 7 et 10 dont les entrées correspondent respectivement aux entrée 51 et 52. Les signaux issus du dispositif 4 sont numérisés et placés respectivement sur les bus de sortie des convertisseurs 7 et 10.

Une première chaîne 6 de numérisation est composée par les dispositifs 3 et 4 ainsi que par le convertisseur 7. Une deuxième chaîne 9 de numérisation est composée des dispositifs 3 et 4 ainsi que du convertisseur 10. Ces deux chaînes 6 et 9 sont caractérisées respectivement par des gains G1 et G2 différents, et G1 est plus petit que G2 par exemple. C'est la raison pour laquelle le dispositif 4 d'amplification a deux sorties. De préférence les gains G1 et G2 sont fixes. Les deux sorties 41 et 42 peuvent comporter une sortie terminale et une sortie intermédiaire d'une suite d'amplificateurs en cascade.

Les bus de sortie des convertisseurs 7 et 10 sont connectés à un dispositif de commutation 11. Dans cet exemple préféré les convertisseurs 7 et 10 étant des convertisseurs 12 bits, il sort de chacun d'eux 12 pistes.

Les 24 pistes au total sont connectés au dispositif 11. Dans un exemple simple, chacune de ces pistes est reliées en cascade à une piste d'un bus 15 de numérisation par un transistor tel que 12. Ces transistors sont commandés en commutation par un signal véhiculé par une ligne 13. La ligne 13 est connectée aux bases des 24 transistors. Entre les douze transistors correspondant au convertisseur 7 et les douze transistors correspondant au convertisseur 10, la ligne 13 contient un inverseur logique 14 pour inverser le signal de commande. Ainsi lorsque les 12 transistors correspondant au convertisseur 7 sont passants, les 12 transistors correspondant au convertisseur 10 ne le sont pas et vice versa. En pratique le commutateur 11 est un peu plus complexe mais cette représentation permet d'en comprendre le fonctionnement. Ce bus 15 avec la ligne 13 forment le bus de sortie du dispositif 11.

Le bus 15 et la ligne 13 sont reliés à une interface 17 entre le dispositif 4 et un bus 16. Le dispositif 5, un microprocesseur 18, un processeur de traitement du signal 19 et une mémoire 20 de programmes sont connectés ensemble par l'intermédiaire du bus 16. L'interface 17 contient dans la pratique un élément de décodage d'adresses, issues du bus 16, qui permet de générer le signal de commande utile pour la ligne 13. Il contient aussi un circuit qui assure la neutralité du dispositif 4 vis-à-vis du bus 16 lorsque le dispositif 4 n'est pas interrogé par le microprocesseur 18. Ces deux éléments sont connus.

La figure 2 détaille la composition des chaînes 6 et 9 de numérisation. La figure 2 montre un amplificateur 201 de gain G201 connecté par sa sortie à l'entrée d'un filtre 202 passe bande de gain G202. Comme le démodulateur 3, l'amplificateur 201 peut commuter entre deux gains. La sortie du filtre 202 est connectée simultanément à l'entrée d'un amplificateur 203 de gain G203 et à l'entrée d'un amplificateur 207 de gain G207. La sortie de l'amplificateur 203 est connectée en cascade avec un mélangeur 204, un amplificateur 205 de gain G205 et le convertisseur 7. Respectivement la sortie de l'amplificateur 207 est connectée en cascade avec un mélangeur 208, un amplificateur 209 de gain G209 et le convertisseur 10. Un oscillateur 211 est connecté simultanément aux mélangeurs 204 et 208.

Les éléments 201 à 205, et 7 constituent la chaîne 6 de numérisation. Les éléments 201, 202, 207 à 209 et 10 constituent la chaîne 9. Le gain G1 de la chaîne 6 est obtenu en combinant les effets amplificateurs, éventuellement atténuateurs, des éléments 201 à 203 et 205 soit :

$$G1 = G201 + G202 + G203 + G205$$

Si les gains sont exprimés en dB. On a de même pour le gain caractérisant la chaîne 9 :

$$G2 = G201 + G202 + G207 + G209.$$

On voit que le gain caractérisant une chaîne de numérisation est réparti sur l'ensemble de la chaîne.

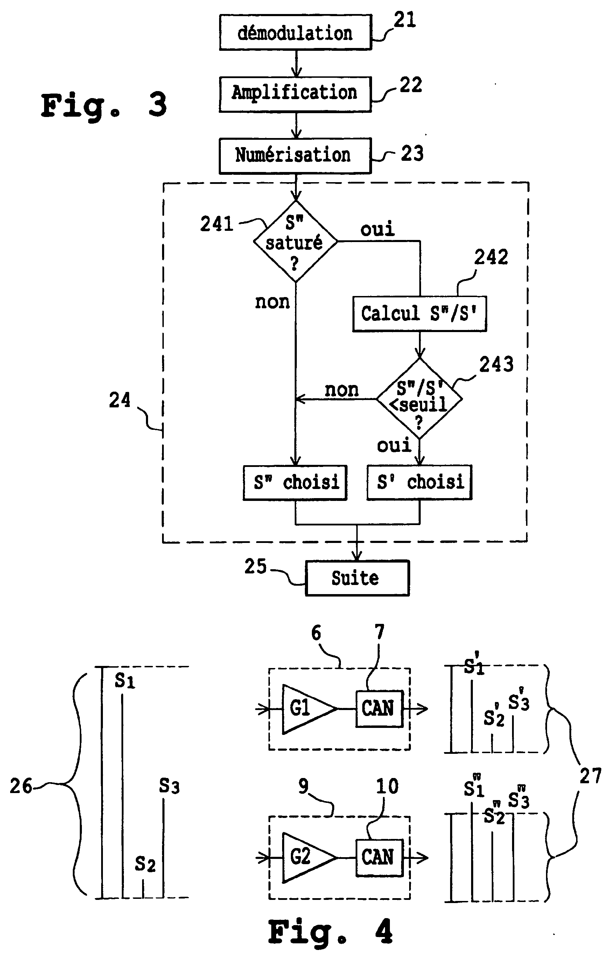

La figure 3 montre les étapes du procédé selon l'invention. Dans une étape préliminaire 21 un téléphone mobile a reçu par l'intermédiaire de son antenne un signal radioélectrique. Le téléphone mobile traite ces signaux radioélectriques afin d'obtenir des signaux démodulés. On passe à une étape d'amplification 22.

Le rôle de cette amplification est de faire passer les signaux reçus de leur plage de dynamique réelle (-110 dBm à 0 dBm), à la plage de dynamique des convertisseurs. Les signaux reçus sont de l'ordre de -110 dBm et plus. Les convertisseurs 7 et 10 sont sensibles à des signaux dont l'ordre de grandeur est -60 dBm ou plus. Il faut amplifier les signaux reçus pour les amener dans un ordre de grandeur compatible avec les convertisseurs. Cependant les signaux démodulés ont une grande dynamique dans leur plage de valeurs. L'amplification des signaux reçus situés dans le bas de la plage de valeur ne doit donc pas se faire avec le même gain que l'amplification des signaux reçus situés dans le haut de la plage. Cela conduirait à une dynamique de signaux amplifiés trop grande pour un convertisseur, d'où l'utilisation de deux amplificateurs 6 et 9 ayant des gains différents.

Dans la pratique, des convertisseurs 12 bits ont une plage d'utilisation allant de -68 dBm à 8 dBm soit 76 dB. Cette dynamique peut être découpée en plusieurs zones ou marges. Une marge $\Delta1$ de -2 dBm à 8 dBm permet d'accepter un accroissement subit du niveau du signal utile. Une marge $\Delta2$ de -68 dBm à -55 dBm assure que le signal numérisé a un rapport signal sur bruit minimum. Et une marge $\Delta3$ de -55 dBm à -32 dBm permet d'accepter une diminution subit du niveau du signal utile. Il reste donc une zone idéale de fonctionnement du convertisseur de -32 dBm à -2 dBm.

Les signaux reçus varient de -110 dBm à 0 dBm. En tenant compte de la marge $\Delta2$, la dynamique utile du convertisseur devient -55 dBm à 8 dBm. En effet, les signaux dont la puissance après filtrage et amplification est comprise entre -68 dBm et -55 dBm peuvent n'être que du bruit, dans ce cas leur signification est nulle. Pour ramener un signal de -110 dBm à -55 dBm, il faut lui appliquer un grand gain de 55 dB. Ce grand gain pourra alors être utilisé pour les signaux reçus de niveaux allant de -110 dBm à -47 dBm. En effet -110 dBm est le signal le plus petit qu'on peut recevoir. Pour les signaux plus forts, et qui passent par la même chaîne d'amplification de 55 dB, après amplification ils ne doivent pas dépasser 8 dBm. Ce qui conduit à ce que les signaux les plus forts admissibles sans écrétage dans cette chaîne soient inférieur à -47 dBm (8 - 55). Pour les signaux reçus de niveaux avant amplification compris entre -46 dBm et 0 dBm on utilisera un petit gain de 8 dB. Ceci pour utiliser le maximum de la dynamique d'entrée du convertisseur. En effet le signal le plus grand qui puisse être reçu a une puissance de 0 dBm. Or le convertisseur admet des signaux allant jusqu'à 8 dBm, un gain de 8 dB ne sature donc pas les signaux les plus forts qui peuvent être reçus.

Ces valeurs de gains, G1 = 8 et G2 = 55, produisent une plage commune de puissance de signal reçu avant amplification de -63 dBm à -47 dBm pour laquelle les deux chaînes 6 et 9 fournissent des valeurs exploitables. -47 dBm (8-55) est la valeur maximum que la chaîne 9 à grand gain puisse numériser sans saturer. -63 dBm (-68-8+13) est la valeur minimale que la chaîne 6 à petit gain puisse numériser avec un rapport signal sur bruit satisfaisant. C'est l'existence de cette plage commune qui garantit l'obtention d'un résultat exploitable quel que soit le signal reçu par le téléphone mobile, à condition bien sur que ce signal soit dans la dynamique réelle de -110 dBm à 0 dBm.

Ces considérations conduisent à des valeurs préférées fixes suivantes pour les gains. Les gains sont exprimés en dB : G201 = 15, G202 = -3, G203 = 0, G 205 = -4, G207 = 20, G209 = 23. Ces valeurs numériques sont données à titre d'exemple, elles dépendent de chaque application.

Les signaux amplifiés sont alors soumis à des conversions à 12 bits, c'est une étape 23 de numérisation. La figure 4 illustre les étapes 22 et 23 par trois exemples.

La figure 4 montre une dynamique 26 (-110 dBm à 0 dBm) des signaux reçus, et une dynamique 27 (-68 dBm à 8 dBm) d'entrée des convertisseurs 12 bits analogiques numériques. La figure 4 représente aussi les deux chaînes de numérisation 6 et 9. La figure 3 illustre le traitement par ces chaînes de trois signaux S1, S2 et S3.

Le premier signal S1 démodulé dont l'amplitude est proche de la dynamique 26 est soumis à l'amplification des deux chaînes 6 et 9. S1 est amplifié de G1 par la chaîne 6 puis numérisé ce qui donne un signal numérique S1'. Le signal S1' reste dans la dynamique 27. S1 est aussi amplifié de G2 par la chaîne 9 et numérisé ce qui donne le signal S1". Le niveau de S1" est bien supérieur à la dynamique 27. Dans ce cas la sortie du convertisseur 10 analogique numérique sera dite saturée, c'est-à-dire que tous les bits à la sortie du convertisseur 10 sont à 1.

Le signal S2 de niveau très inférieur à la dynamique 26 est soumis aux deux chaînes de numérisation 6 et 9. Traité par la chaîne 5, le signal S2 donne un signal S2' dont le niveau est très inférieur à la dynamique 27. Traité par la chaîne 8 le signal S2 donne le signal S2" dont le niveau est légèrement inférieur à la dynamique 27.

Le signal S3 est au centre de la dynamique 26. Traité par la chaîne 5 il donne un signal S3' inférieur à la dynamique 27. Alors que traité par la chaîne 8 il donne un signal S3" légèrement supérieur à la dynamique 27.

La figure 4 illustre donc trois des cas auxquels le microprocesseur 18 peut se retrouver confronté. A chacun de ces cas, le microprocesseur 18 doit décider quel est l'échantillon le meilleur entre S' ou S". C'est le traitement d'une étape 24 de sélection de la sortie.

Dans l'étape 24 le microprocesseur 18 doit donc étudier deux signaux numériques représentant la même information et issus du dispositif 5. L'étude de ces signaux est réalisée par le microprocesseur 18 grâce à un programme contenu dans la mémoire 20. Cependant au vu de la simplicité de ce programme, sa mise en oeuvre peut être réalisée par un circuit matériel intégré dans le silicium. Une telle démarche produirait encore un gain de temps.

Dans un premier temps le microprocesseur 18 détermine si un des signaux est saturé. Dans la pratique seul le signal S", issu de la chaîne 9, peut être saturé. En effet le gain G1 étant le plus petit il est dimensionné de manière à faire en sorte que les signaux reçus ayant la plus grande amplitude ne saturent pas le convertisseur 7. Le microprocesseur 18 regarde donc si les bits issus de la chaîne 9 (au moins des bits de poids fort) sont tous à 1 ou pas. S'ils ne sont pas tous à 1, le microprocesseur 18 sait alors qu'il est en présence du signal le meilleur. En effet le gain G2 étant supérieur au gain G1, le signal S" a donc plus de dynamique que le signal S'. La figure 3 illustre cet exemple avec le traitement du signal S" par le test 241.

Si le signal S" issu de la chaîne 9 est saturé, le microprocesseur doit calculer par une étape 242 le rapport entre S" et S'. Il compare alors le rapport obtenu et le rapport entre G2 et G1. Dans un exemple ce rapport entre G2 et G1 vaut 562/2.5 ($10^{G2/20}$ / $10^{G1/20}$, si G1 et G2 sont exprimés en dB). Ce rapport entre G2 et G1 est connu d'avance et il peut être précalculé. Seul le rapport S"/S' doit être calculé. Ce dernier calcul peut être très rapide. Au cours d'un test 243 on regarde si les deux rapports sont proches, le cas échéant cela signifie que le signal S" est en limite de saturation. Dans la limite d'une tolérance fixée par un seuil, le microprocesseur 18 choisira alors le signal S". En cas de tolérance nulle ou si le rapport entre S" et S' est inférieur au rapport entre G2 et G1, le signal choisi sera le signal S'. Cet exemple est illustré par le traitement du signal S3 de la figure 3.

Si l'écart entre les rapports est important le microprocesseur 18 choisira le signal S'. En effet on est dans le cas du traitement du signal S1 de la figure 3.

Dans une variante de l'invention on peut fixer un seuil Sr relatif à la sortie du convertisseur 7. Si la sortie du convertisseur 7 est supérieure à Sr, le microprocesseur 8 sait que la sortie que la sortie de la chaîne 9 est saturée et que l'échantillon exploitable est celui issu de la chaîne 6. Si la sortie du convertisseur 7 est inférieure à Sr, la sortie de la chaîne 9 est exploitable. Dans la pratique, et avec les valeurs G1 et G2 choisie, Sr est la valeur obtenue par la chaîne 6 pour un signal à l'entrée du téléphone mobile ayant une puissance de -47 dBm, c'est à dire le haut de la plage commune aux chaînes 6 et 9. En variante, si aucun des signaux n'est saturé, on choisit celui dont le bit de poids fort a le rang le plus élevé.

Cette méthode de discrimination présente de nombreux avantages par rapport aux solutions existantes. En effet dans le pire des cas, les calculs à mettre en oeuvre sont un test, une division, et un autre test. Avec les microprocesseurs actuels, chacune de ces opérations peut se faire en un cycle d'horloge. On est bien loin du nombre important de cycles nécessaires pour l'analyse du signal, auquel se rajoute un nombre de cycles encore plus important nécessaire à l'ajustement du gain d'un amplificateur à gain variable. De plus avec l'invention, on ne perd jamais une information : un des signaux issus du dispositif 5 est en effet toujours dans la dynamique 27, donc exploitable. Il n'y a jamais de perte due au temps de commutation car cette commutation est à posteriori du calcul.

Dans une variante de l'invention, on peut se baser sur le calcul de la valeur efficace des signaux en sortie du dispositif 4 pour choisir le signal le meilleur. La valeur efficace est obtenue en calculant la somme du carré des échantillons et en divisant cette somme par le nombre d'échantillons. Ce calcul peut être effectué par le processeur 19, ou des fonctions avancées de calcul du microprocesseur 18. En effet dans le cadre d'une intégration poussée, le processeur 19 peut être contenu dans un même circuit intégré que le microprocesseur 18. Le meilleur échantillon est alors celui dont la valeur efficace est la plus élevée. Il faut cependant tenir compte des cas où les échantillons sont saturés. Cette solution bien que plus lourde en calcul que la précédente est toujours affranchie d'un contrôle de gain, donc d'un temps de montée de gain analogique. De même, avec cette solution il n'y a jamais de perte d'informations, puisqu'il y a toujours un échantillon compris dans la dynamique 27 donc exploitable par le microprocesseur 18.

Dans une variante, l'invention se sert des deux signaux issus du dispositif 5 pour reconstruire un signal numérique représentant le signal démodulé issu du dispositif 3. On peut ainsi accroître la dynamique du signal final obtenu. Pour ce faire, on utilise le signal issu de la chaîne 5 pour les bits de poids forts, et le signal issu de la chaîne 8 pour les bits de poids faibles.

## Revendications

1. Téléphone (1) mobile comportant :

   - un dispositif (3) de démodulation de signaux radioélectriques reçus par le téléphone mobile, et produisant des signaux démodulés, et
   - un dispositif (5) de numérisation des signaux démodulés,

   **caractérisé en ce que**:

   - il comporte deux chaînes (6, 9) de numérisation en parallèle, et ayant chacune un gain d'amplification distinct.
- chaque chaîne de numérisation comporte en cascade un amplificateur (4) analogique et un convertisseur (7, 10) analogique numérique.

2. Téléphone selon la revendication 1, **caractérisé en ce que** les gains des chaînes de numérisation sont différents.

3. Téléphone selon l'une des revendications 1 ou 2, **caractérisé en ce que** les convertisseurs ont une dynamique de 12 bits.

4. Téléphone selon l'une des revendications 1 à 3, **caractérisé en ce que** les gains des chaînes de numérisation sont fixes.

5. Téléphone selon l'une des revendications 1 à 4, **caractérisé en ce que** le dispositif de numérisation comporte une sortie pour chaque convertisseur et des moyens (12, 13, 16, 18) de commutation permettant de sélectionner une des sorties de convertisseurs.

6. Téléphone selon l'une des revendications 1 à 5, **caractérisé en ce que** le dispositif de démodulation est double et comporte un démodulateur (204, 208) dans chaque chaîne de numérisation.

7. Procédé de numérisation de signaux radioélectriques par un téléphone mobile **caractérisé en ce que** :

   - on reçoit un signal radioélectrique et on produit deux signaux démodulés (21),
   - on amplifie (22) les signaux démodulésavec deux gains différents, afin d'obtenir deux signaux amplifiés d'amplitudes distinctes,
   - on numérise (23) les deux signaux amplifiés afin d'obtenir des signaux numérisés, et
   - on choisit (24) un des deux signaux numérisés.

8. Procédé selon la revendication 7, **caractérisé en ce que**

   - on choisit le signal numérique dont le rang du bit de poids fort et le plus élevé, si le signal n'est pas saturé.

9. Procédé selon la revendication 9, **caractérisé en ce que**

   - on calcule le rapport des signaux numérisés,
   - on le compare au rapport des gains des amplificateurs ; si les deux rapports sont proches,
   - on choisit le signal numérique correspondant à la chaîne de numérisation ayant le gain le plus élevé
- sinon on choisit l'autre.

10. Procédé selon la revendication 9, **caractérisé en ce que**

   - on fixe un seuil Sr, relatif à la chaîne ayant le gain le plus faible, tel que un signal d'entrée des chaînes de numérisation fournissant Sr à la sortie de la chaîne ayant le gain le plus faible, fournit un signal en limite de saturation à la sortie de la chaîne ayant le plus grand gain,
   - on compare la sortie S' de la chaîne ayant le gain le plus faible à Sr,
   - si S' est supérieur à Sr alors on choisit S',
   - sinon on choisit la sortie S" de la chaîne ayant le plus grand gain.

11. Procédé selon l'une des revendications 7 à 10, **caractérisé en ce qu'**on reconstitue un signal numérique à partir des deux signaux numérisés en utilisant le signal correspondant à la chaîne de numérisation ayant le gain le plus petit comme signal grossier, et l'autre signal comme signal de détail.

**Patentansprüche**

1. Mobiltelefon (1) umfassend:

   - eine Einrichtung (3) zur Demodulation von durch das Mobiltelefon empfangenen Funksignalen und zur Erzeugung demodulierter Signale, und
   - eine Einrichtung (5) zur Digitalisierung der demodulierten Signale,

   **dadurch gekennzeichnet, dass**:

   - dieses zwei Ketten (6, 9) zur Paralleldigitalisierung aufweist, wobei jede einen anderen Verstärkungsgewinn hat.
   - jede Digitalisierungskette in Kaskadenanordnung einen Analogverstärker (4) und einen Analog-/Digitalwandler (7, 10) aufweist.

2. Telefon nach Anspruch 1, **dadurch gekennzeichnet, dass** die Gewinne der Digitalisierungsketten unterschiedlich ausfallen.

3. Telefon nach Anspruch 1 oder 2, **dadurch gekennzeichnet, dass** die Wandler eine 12 Bit Dynamik haben.

4. Telefon nach einem der Ansprüche 1 bis 3, **dadurch gekennzeichnet, dass** die Gewinne der Digitalisierungsketten fest sind.

**5.** Telefon nach einem der Ansprüche 1 bis 4, **dadurch gekennzeichnet, dass** die Digitalisierungseinrichtung einen Ausgang für jeden Wandler aufweist und Umschaltmittel (12, 13, 16, 18), welche die Auswahl eines der Ausgänge der Wandler gestatten.

**6.** Telefon nach einem der Ansprüche 1 bis 5, **dadurch gekennzeichnet, dass** die Demodulationseinrichtung doppelt ist und einen Demodulator (204, 208) in jeder Digitalisierungskette aufweist.

**7.** Verfahren zur Digitalisierung von Funksignalen durch ein Mobiltelefon, **dadurch gekennzeichnet, dass**:

- ein Funksignal empfangen wird und zwei demodulierte Signale erzeugt werden (21),
- die demodulierten Signale mit zwei unterschiedlichen Gewinnen verstärkt werden (22), um zwei mit unterschiedlichen Amplituden verstärkte Signale zu erhalten,
- die beiden verstärkten Signale digitalisiert werden (23), um digitalisierte Signale zu erhalten, und
- eines der beiden digitalisierten Signale ausgewählt wird (24).

**8.** Verfahren nach Anspruch 7, **dadurch gekennzeichnet, dass**

- das digitale Signal ausgewählt wird, bei dem der Rang des Bits mit dem höchsten Stellenwert am höchsten ist, falls das Signal nicht gesättigt ist.

**9.** Verfahren nach Anspruch 9, **dadurch gekennzeichnet, dass**

- das Verhältnis der digitalisierten Signale berechnet wird,
- dieses mit dem Verhältnis der Gewinne der Verstärker verglichen wird; wenn die beiden Verhältnisse nahe beieinander liegen,
- das digitale Signal ausgewählt wird, weiches der Digitalisierungskette mit dem höchsten Gewinn entspricht,
- ansonsten das andere ausgewählt wird.

**10.** Verfahren nach Anspruch 9, **dadurch gekennzeichnet, dass**

- eine solche Schwelle Sr, bezüglich der Kette mit dem schwächsten Gewinn, festgelegt wird, dass ein Eingangssignal der Digitalisierungsketten, welches Sr an den Ausgang der Kette mit dem schwächsten Gewinn liefert, ein Signal an der Grenze zur Sättigung an den Ausgang der Kette mit dem größten Gewinn liefert,

- der Ausgang S' der Kette mit dem schwächsten Gewinn mit Sr verglichen wird,
- falls S' Sr übertrifft, S' ausgewählt wird,
- andernfalls der Ausgang S" der Kette mit dem größten Gewinn ausgewählt wird.

**11.** Verfahren nach einem der Ansprüche 7 bis 10, **dadurch gekennzeichnet, dass** ein digitales Signal wiederhergestellt wird ausgehend von zwei digitalisierten Signalen unter Verwendung des Signals, welches der Digitalisierungskette mit dem kleinsten Gewinn entspricht, als elementares Signal, und des anderen Signals als Detailsignal.

**Claims**

**1.** Mobile telephone (1) including:

- a device (3) for demodulation of radio-electric signals received by the mobile telephone and producing demodulated signals, and
- a device (5) for digitising the demodulated signals,

**characterised by** the fact that:

- it includes two parallel digitising chains (6, 9), each having a distinct amplification gain.
- each digitising chain includes in cascade an analogue amplifier (4) and an analogue digital converter (7, 10).

**2.** Telephone as described in claim 1, **characterised by** the fact that the gains of the digitising chains are different.

**3.** Telephone as described in one of claims 1 or 2, **characterised by** the fact that the converters have a 12 bit dynamic range.

**4.** Telephone as described in one of claims 1 to 3, **characterised by** the fact that the gains of the digitising chains are fixed.

**5.** Telephone as described in one of claims 1 to 4, **characterised by** the fact that the digitising device includes an output for each converter and switching means (12, 13, 16, 18) permitting selection of one of the converter outputs.

**6.** Telephone as described in one of claims 1 to 5, **characterised by** the fact that the demodulation device is double and includes a demodulator (204, 208) in each digitising chain.

**7.** Process for digitisation of radio-electric signals by a mobile telephone, **characterised by** the fact that:

- a radioelectric signal is received and two demodulated signals are produced (21),
- the demodulated signals are amplified (22) with two different gains, in order to obtain two amplified signals of distinct amplitudes,
- the two amplified signals are digitised (23) in order to obtain digitised signals, and
- one of the two digitised signals is selected (24).

8. Process as described in claim 7, **characterised by** the fact that:

   - the digital signal is selected which has the most significant bit of highest rank, if the signal is not saturated.

9. Process as described in claim 9, **characterised by** the fact that:

   - the ratio of the digitised signals is calculated,
   - it is compared with the ratio of the gains of the amplifiers; if the two ratios are close,
   - the digital signal is selected corresponding to the digitising chain having the highest gain
   - otherwise the other is selected.

10. Process as described in claim 9, **characterised by** the fact that:

    - a threshold Sr is fixed, relative to the chain having the lowest gain, such that an input signal of the digitising chains providing Sr at the output of the chain having the lowest gain provides a saturation limit signal at the output of the chain having the highest gain,
    - the output S' of the chain having the lowest gain is compared with Sr,
    - if S' is higher than Sr, then S' is selected,
    - otherwise the output S" of the chain having the highest gain is selected.

11. Process as described in one of claims 7 to 10, **characterised by** the fact that a digital signals reconstructed from the two digitised signals using the signal corresponding to the digitising chain having the lowest gain as the coarse signal and the other signal as the detail signal.

**Fig. 1**

**Fig. 2**

## Fig. 3

démodulation — 21

Amplification — 22

Numérisation — 23

241 — S" saturé ? → oui

non

242 — Calcul S"/S'

243 — S"/S' <seuil ?

non →

24

oui

S" choisi     S' choisi

25 — Suite

---

26 — S1 S3 S2

6 — G1   7 — CAN

9 — G2   10 — CAN

S'1 S'2 S'3

S"1 S"2 S"3

27

## Fig. 4